(19) Europäisches Patentamt
European Patent Office
Office européen des brevets

(11) **EP 4 059 708 B1**

(12) **EUROPEAN PATENT SPECIFICATION**

(45) Date of publication and mention
of the grant of the patent:
**08.05.2024 Bulletin 2024/19**

(21) Application number: **20886246.6**

(22) Date of filing: **22.10.2020**

(51) International Patent Classification (IPC):
**B32B 15/08** (2006.01)     **G09F 19/12** (2006.01)
**B32B 7/023** (2019.01)     **G09F 13/04** (2006.01)
**B32B 27/08** (2006.01)     **C23C 14/20** (2006.01)
**B32B 27/30** (2006.01)     **B32B 27/36** (2006.01)

(52) Cooperative Patent Classification (CPC):
**B32B 27/08; B32B 27/308; B32B 27/36;
C23C 14/20;** B32B 2250/02; B32B 2255/10;
B32B 2255/205; B32B 2307/412; B32B 2590/00

(86) International application number:
**PCT/JP2020/039720**

(87) International publication number:
**WO 2021/095479 (20.05.2021 Gazette 2021/20)**

(54) **LAMINATED FILM, METALLIC PRODUCT, AND METALLIC SIGNBOARD**

SCHICHTFILM, METALLTONPRODUKT UND METALLBESCHILDERUNG

FILM STRATIFIÉ, ARTICLE IMITATION MÉTAL, ET ENSEIGNE IMITATION MÉTAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.11.2019 JP 2019204055**

(43) Date of publication of application:
**21.09.2022 Bulletin 2022/38**

(73) Proprietor: **OIKE & CO., LTD.
Kyoto-shi, Kyoto 600-8461 (JP)**

(72) Inventor: **AKAZA, Yoshihiro
Kyoto-shi, Kyoto 601-8123 (JP)**

(74) Representative: **Bryn Aarflot AS
Patent
Stortingsgata 8
0161 Oslo (NO)**

(56) References cited:
**WO-A1-2006/102581     WO-A1-2020/178981
CN-A- 103 057 211     JP-A- 2000 094 575
JP-A- 2001 310 415     JP-A- 2006 026 946
JP-A- 2012 116 219     JP-A- 2020 132 998
JP-A- 2020 157 691**

**Description**

TECHNICAL FIELD

The present invention relates to a laminated film, a metallic product, and a metallic signboard. More specifically, the present invention relates to a laminated film, a metallic product, and a metallic signboard, which are excellent in molding processability, and which, when processed into a molded product, can obtain a metallic appearance in the daytime and satisfactorily transmit light from a light source from the back surface in the nighttime.

BACKGROUND ART

Conventionally, a metallic product with a metal decoration material has been developed for indoor and outdoor signboards, etc., which obtains a metallic appearance in the daytime and satisfactorily transmits light from a light source from the back surface in the nighttime. As such a metal decoration material, a metallic product using a laminated film with a thin film of aluminum has been known. Moreover, in general, the laminated film for imparting with a metallic appearance may be of chromium, indium, or the like, besides aluminum (Patent Document 1).

PRIOR ART DOCUMENT

Patent Document

Patent Document 1: JP 2006-26946 A

Patent Document 2: WO 2006/102581 A1 teaching corrosion-resistant metallized films and methods of making the same. The corrosion-resistant metallized film comprises: a polymeric primer layer having a first surface; a metal layer adjacent the first surface of the polymeric primer layer; and a polymeric protective layer adjacent the metal layer, where the protective layer has a second surface in contact with the metal layer; and where the first and second surfaces have a similar surface charge and jointly provide corrosion resistance to the metal layer.

Patent Document 3: JP 2012-116219 A teaching a metal tone decorative sheet and a method for manufacturing the metal tone decorative sheet being capable of preventing occurrence of operation failures of a capacitance sensor and being capable of increasing production efficiency during small amount production.

However, a laminated film on which aluminum is deposited has a poor followability when molded into a variety of three-dimensional shapes, and it easily causes appearance defects such as whitening after the molding process. Therefore, when aluminum is deposited, a method of providing a deposited layer by batch deposition is adopted. However, the thin aluminum film obtained is inferior in durability, therefore requiring a topcoat. Moreover, producing a laminated film by batch deposition takes a high cost.

SUMMARY OF THE INVENTION

Meanwhile, instead of aluminum, it is conceivable to deposit other metals such as indium. However, for example, a laminated film provided with a deposited layer made of indium is inferior in transparency as compared with the case where aluminum is used. Therefore, it has been considered that the laminated film with indium is not suitable for use in the above-described metallic products such as signboards.

The present invention has been made in view of such a conventional invention, and it is an object of the present invention to provide a laminated film, a metallic product, and a metallic signboard, which are excellent in molding processability, and which, when processed into a molded product, can obtain a metallic appearance in the daytime and satisfactorily transmit light from a light source from the back surface in the nighttime.

As a result of intensive studies, the present inventor has found that molding processability becomes excellent, and when processing into a molded product, a metallic appearance can be obtained in the daytime and light from a light source can be satisfactorily transmitted from the back surface in the nighttime, by adopting indium as a metal deposition layer, and adjusting an OD (optical density) value to be equal to or lower than a predetermined range and adjusting so that the OD value and an a* value and a b* value of the transmitted light in a L*a*b* color space satisfy a predetermined relationship, and completed the present invention according to claim 1.

The laminated film of the present invention that solves the above-described problems comprises a base material, an anchor layer, a metal deposition layer, and a bonding layer, according to claim 1 , the metal deposition layer comprising indium, wherein an OD value is 1.2 or less, and wherein an a* value and a b* value of a transmitted light in a L*a*b* color space satisfy the following inequality (1):

$$\text{OD value} \times (a^{*2} + b^{*2})^{1/2} \leq 6.7 \ ... \ (1)$$

The metallic product of the present invention that solves the above-described problems is a metallic product using the above-described laminated film.

The metallic signboard of the present invention that solves the above-described problems is a metallic signboard using the above-described laminated film.

EMBODIMENT FOR CARRYING OUT THE INVENTION

<Laminated film>

The laminated film of one embodiment, according to claim 1, of the present invention comprises a base material, an anchor layer, a metal deposition layer, and a bonding layer. The metal deposition layer comprises indium. The OD value is 1.2 or less. The a* value and the b* value of the transmitted light in the L*a*b* color space satisfy the following inequality (1). Each will be described below.

$$\text{OD value} \times (a^{*2} + b^{*2})^{1/2} \leq 6.7 \ ... \ (1)$$

(Base material)

The base material is not particularly limited. By way of an example, the base material includes poly (meth)acrylic acid ester such as polymethyl methacrylate (PMMA), polycarbonate, polyethylene terephthalate, polyethylene-2,6-naphthalate, polyvinyl fluoride (PVF), polyvinylidene fluoride (PVDF), polytetrafluoroethylene (PTFE), polychlorotrifluoroethylene (PCTFE), ethylene-tetrafluoroethylene copolymer (ETFE), ethylene-chlorotrifluoroethylene copolymer (ECTFE), tetrafluoroethylene-perfluoro alkyl vinyl ether copolymer (PFA), tetrafluoroethylene-hexafluoropropylene copolymer (FEP).

A thickness of the base material is not particularly limited. By way of an example, the thickness of the base material is preferably 1.0 to 300 μm. When the thickness of the base material is within the above-described range, the laminated film is excellent in scratch resistance and abrasion resistance.

As the base material, one subjected to a desired surface processing may be used. The surface processing is not particularly limited. By way of an example, the surface processing includes matt processing, satin processing, emboss processing, hairline processing, and the like. Moreover, surface processing such as various types of coatings (fluorine processing, hard coat processing, etc.) and transfer may be applied to a surface of the base material (a surface opposite to a surface on which an anchor layer is formed). As a result, various types of designs and functionalities can be imparted to the surface of the base material.

(Anchor layer)

The anchor layer is provided for improving adhesiveness between the base material and the metal deposition layer.

The anchor layer is not particularly limited. By way of an example, the anchor layer may be a raw material having a good adhesiveness to the base material and a good receptivity of indium constituting the metal deposition layer, including an acryl-based resin, a nitrocellulose-based resin, a polyurethane-based resin, a polyester-based resin, a styrene-mallein-based acid resin, a chlorinated PP-based resin.

A thickness of the anchor layer is not particularly limited. By way of an example, the thickness of the anchor layer is preferably 0.1 to 3 μm. When the thickness of the anchor layer is within the above-described range, the laminated film is excellent in adhesiveness between the base material and the metal deposition layer.

The anchor layer may be imparted with a design property by being applied with a colorant or a metal pigment. For example, the laminated film can express a golden appearance by being compounded with a yellow pigment as a colorant. A type and a content of the colorant can be appropriately adjusted according to a desired metallic appearance. Moreover, the anchor layer may be imparted with functionality such as an antistatic effect by being compounded with an antistatic agent.

(Metal deposition layer)

The metal deposition layer comprises indium. It may comprise indium as oxide or nitride. When the metal deposited layer comprises indium, the laminated film obtained is less likely to cause appearance defects such as whitening during the molding process and is excellent in molding processability. As a result, the laminated film is easily processed into a variety of three-dimensional shapes.

Moreover, the metal deposition layer may comprise various types of non-metals, metals, metal oxides, and metal nitrides, in addition to indium. Non-metals, metals, and the like are not particularly limited. By way of an example, non-metals include amorphous carbon (DLC) and its composite, and metals and the like include metals such as gold, silver, platinum, tin, chromium, silicon, titanium, zinc, aluminum, and magnesium, and oxides and nitrides thereof.

A content of indium in the metal deposition layer is not particularly limited. By way of an example, the content of indium in the metal deposition layer is preferably 95% by mass or more, more preferably 98% by mass or more. The content of indium may be 100% by mass.

A thickness of the metal deposition layer is not particularly limited. The thickness of the metal deposition layer is 10 nm or more, preferably 15 nm or more. The thickness of the metal deposition layer is 20 nm or less. When the thickness of the metal-deposited layer is within the above-described ranges, the metal-deposited layer easily achieves both metallic luster and moldability. Moreover, the laminated film obtained becomes able to not only increase transmittance but also reduce a transmission haze. As a result, cloudiness of the transmitted light obtained is reduced, and the transmitted light can express a good color tone.

(Bonding layer)

The bonding layer is provided for adhering the laminated film to an adherend.

The bonding layer is not particularly limited. By way of an example, the bonding layer includes various types of bonding agents, adhesives, and pressure sensitive adhesives (PSA). The bonding agent is not particularly limited. By way of an example, the bonding agent is of acrylic resin-based, urethane resin-based, urethane-modified polyester resin-based, polyester resin-based, epoxy resin-based, ethylene-vinyl acetate copolymer resin (EVA)-based, vinyl resin-based (vinyl chloride, vinyl acetate, a vinyl chloride/vinyl acetate copolymer resin), styrene-ethylene-butylene copolymer resin-based, polyvinyl alcohol resin-based, polyacrylamide resin-based, polyacrylamide resin-based, resin such as an isobutylene rubber, an isoprene rubber, a natural rubber, a SBR, a NBR, and a silicone rubber. These types of resin may be dissolved in a solvent and used in an appropriate manner, or may be used without a solvent.

The bonding layer comprises a colorant. In general, a laminated film provided with a metal deposition layer made of indium becomes a brownish-red transmitted light when light from a light source is transmitted from the back surface, and easily becomes inferior in color hue. On the other hand, by compounding a colorant in the bonding layer, the color tone of the transmitted light from the light source can be adjusted. As a result, the laminated film can be adjusted to transmit a transmitted light with a desired color tone(for example, a blue-based color tone, etc.).

The colorant comprises at least one of a blue pigment and a magenta pigment when a bluish color tone is desired. Therefore, the colorant can adjust the transmitted light from the light source to have a blue-based color tone.

Types of blue pigment and magenta pigment are not particularly limited. The types of blue pigment and magenta pigment may be appropriately selected according to a desired color tone of a transmitted light.

Contents of the blue pigment and the magenta pigment are not particularly limited. The contents of the blue pigment and the magenta pigment may be appropriately selected according to a desired color tone of a transmitted light. By way of an example, the contents of the blue pigment and the magenta pigment are more than 0% by mass, preferably 8% by mass or less, in a resin solution constituting a bonding layer. Therefore, the color tone of the transmitted light can be appropriately imparted with a blue-based color tone.

A method of forming a bonding layer is not particularly limited. By way of an example, the bonding layer may be formed by applying a resin solution constituting the bonding layer appropriately dissolved in a solvent to a separator which will be described later, using a roll coater or the like, and then attaching the separator on which the bonding layer is formed to a metal deposition layer, or by applying the above-described resin solution directly onto the metal deposition layer. Moreover, as the bonding layer, a ready-made product in which a bonding layer is provided on a separator may be used. The method of forming a bonding layer can be appropriately selected according to characteristics of a bonding agent or an adhesive to be used.

A thickness of the bonding layer is not particularly limited. By way of an example, the thickness of the bonding layer is preferably 10 $\mu$m or more, more preferably 15 $\mu$m or more. The thickness of the bonding layer is preferably 60 $\mu$m or less, more preferably 55 $\mu$m or less. When the thickness of the bonding layer is within the above-described ranges, the laminated film obtained is further excellent in appearance and bonding property at the time of bonding.

The bonding layer may be imparted with a design property by being applied with a metal pigment, besides the above-described colorant. Moreover, the bonding layer may be imparted with functionality such as an antistatic effect by being compounded with an antistatic agent. Therefore, the bonding layer can improve in suitability for attachment.

Returning back to the description of the entire laminated film, an OD (Optical Density) value of the laminated film may be 1.2 or less, preferably 1.1 or less. The OD value is a parameter indicating light transparency and can be measured using, for example, a transmission densitometer (DM-500, manufactured by SCREEN Holdings Co., Ltd.). When the OD value of the laminated film of this embodiment exceeds 1.2, the laminated film becomes difficult to transmit light from the light source when processed into a molded product. On the other hand, when the OD value of the laminated film is within the above-described ranges, the laminated film becomes easy to appropriately transmit light from the light source when processed into a molded product.

In the laminated film of this embodiment, the OD value and the a* value and the b* value of the transmitted light in the L*a*b* color space may satisfy the following inequality (1), preferably the following inequality (2):

$$\text{OD value} \times (a^{*2} + b^{*2})^{1/2} \leq 6.7 \ldots (1)$$

$$\text{OD value} \times (a^{*2} + b^{*2})^{1/2} \leq 6.0 \ldots (2)$$

The laminated film of this embodiment can easily obtain a metallic appearance in the daytime and satisfactorily transmit light from the light source in the nighttime when processed into a molded product by the OD value and the a* value and the b* value of the transmitted light in the L*a*b* color space satisfying the inequality (1).

As specified in the inequality (1) and the inequality (2), the laminated film of this embodiment becomes difficult to transmit light from the light source in a case where the OD value is somewhat lower than 1.2 (for example, in a case where the OD value is about 1.0), as compared with a case where the OD value is lower than the former case. As a result, the influence of the value of "$(a^{*2} + b^{*2})^{1/2}$" (that is, the color tone of the transmitted light) becomes large. Therefore, in order to satisfy "OD value $\times (a^{*2} + b^{*2})^{1/2} \leq 6.7$", both the a* and the b* in "$(a^{*2} + b^{*2})^{1/2}$" are preferably $\pm$ 4.0 or less, more preferably $\pm$ 3.5 or less. As a result, the laminated film of this embodiment easily satisfies the inequality (1) even when the OD value is relatively high, and easily achieves both reflectivity in the daytime and transparency in the nighttime.

On the other hand, in a case where the OD value is further lower than 1.2 (for example, in a case where the OD value is about 0.8), light from the light source becomes easily transmitted, as compared with a case where the OD value is higher than the former case (for example, about 1.0). As a result, the influence of the value of "$(a^{*2} + b^{*2})^{1/2}$" (that is, the color tone of the transmitted light) becomes small. Therefore, in order to satisfy "OD value $\times (a^{*2} + b^{*2})^{1/2} \leq 6.7$", both the a* and the b* in "$(a^{*2} + b^{*2})^{1/2}$" are preferably $\pm$ 5.5 or less, more preferably $\pm$ 5.0 or less. As a result, the laminated film of this embodiment easily satisfies the inequality (1) even when the OD value is relatively low, and easily achieves both reflectivity in the daytime and transparency in the nighttime.

Moreover, in the laminated film of this embodiment, a brightness L* value of a reflected light in the L*a*b* color space is preferably 60 or more, more preferably 70 or more. When the brightness L* value of the reflected light is within the above-described ranges, the laminated film not only exhibits an excellent transparency but also improves in reflected brightness (reflectance). As a result, the laminated film easily obtains a metallic appearance in the daytime.

In this embodiment, both "the transmitted light and the reflected light in the L*a*b* color space" can be measured, for example, under a condition of using a halogen lamp as the light source, an integrating sphere received light including a specular reflection as the reflected light (a geometric condition d (8°: di)), and an integrating sphere received light including a specular transmission as the transmitted light (geometric condition d (0°: di)), according to JIS K 8722 and CIE 1976, using an ultraviolet-visible near-infrared spectrophotometer (UV-3600, manufactured by Shimadzu Corporation).

As described above, in the laminated film of this embodiment, the metal deposition layer comprises indium. Therefore, the laminated film is excellent in followability to the three-dimensional shape at the time of molding, as compared with a metal deposition layer made of aluminum. As a result, whitening and the like are less likely to occur, and a molded product having an excellent appearance is easily obtained. Moreover, in the laminated film, an OD value is included in a predetermined numerical range, and the above-described inequality (1) is satisfied which is composed of the OD value and an a* value and a b* value of a transmitted light in a L*a*b* color space. As a result, the laminated film can obtain a metallic appearance in the daytime and satisfactorily transmit light from the light source in the nighttime.

Moreover, since the laminated film of this embodiment can obtain a metallic appearance in the daytime and satisfactorily transmit light from the light source in the night, for example, it can be appropriately utilized for applications of the metallic product having a variety of three-dimensional shapes.

The metallic product of one embodiment of the present invention is a metallic product using the above-described laminated film. The metallic product is produced by attaching the above-described laminated film to an adherend.

The adherend is not particularly limited. By way of an example, the adherend includes resin such as polypropylene, acryl, polystyrene, polyacrylonitrile-styrene, polyacrylonitrile-butadiene-styrene, and the like. The adherend preferably has translucency so that it can transmit light emitted by the light source from the back surface after processed into a molded product.

The metallic product obtained exhibits a metallic appearance due to a metal deposition layer comprising indium in the daytime. On the other hand, in the nighttime, light can be transmitted towards the outside by irradiating with light from the light source from the back surface.

The metallic product is not particularly limited. By way of an example, the metallic product includes a metallic signboard, an interior/exterior metallic member for a vehicle, a metallic home appliance, a metallic amusement product, a metallic building material, and the like. Among them, when the metallic product is a metallic signboard using the above-described laminated film, it can exhibit an excellent metallic appearance in the daytime and an excellent light transparency in the nighttime.

<Methods of producing laminated film and metallic product>

The methods of producing the above-described laminated film and metallic product are not particularly limited. By way of an example, the method of producing the laminated film mainly comprises a step of forming an anchor layer on the above-described base material (an anchor layer forming step), a step of forming a metal deposition layer on the anchor layer (a depositing step), and a step of forming a bonding layer on the metal deposition layer (a bonding layer forming step). The obtained laminated film is processed into a molded product (metallic product) by being molded.

· Anchor layer forming step

First, an anchor layer is formed on the prepared base material. The method of forming the anchor layer is not particularly limited. By way of an example, the anchor layer can be formed by applying a resin solution constituting the anchor layer appropriately dissolved in a solvent onto the base material using a roll coater or the like.

· Depositing step

Next, a metal deposition layer is formed on the anchor layer (a depositing step). The method of forming the metal deposition layer is not particularly limited. By way of an example, as the deposition method, a physical deposition method such as a vacuum deposition method, a sputtering method and an ion plating method, or a chemical deposition method, or the like, which are conventionally known methods, can be appropriately adopted. Among them, a vacuum deposition method is preferably adopted to provide a metal deposition layer because of its high productivity. As a deposition condition, a conventionally known condition can be appropriately adopted based on a desired thickness of the metal deposition layer. Besides, a metal material preferably has few impurities and has a purity of preferably 99% by mass or more, more preferably 99.5% by mass or more. Moreover, the metal material is preferably processed into a granular shape, a rod shape, a tablet shape, a wire shape, or a crucible shape to be used. As a heating method for evaporating the metal material, a well-known method can be used such as a method of putting the metal material in a crucible and performing a resistance heating or high frequency heating, a method of performing an electron beam heating, and a method of putting the metal material in a board made of ceramics such as boron nitride and directly performing a resistance heating. A crucible used for vacuum deposition is preferably made of carbon or may be a crucible made of alumina, magnesia, titania, or beryllia.

· Bonding layer forming step

Next, a bonding layer is formed on the metal deposition layer (a bonding layer forming step). The bonding layer is provided for applying the laminated film of this embodiment to the adherend to produce a molded product (metallic product).

The method of forming a bonding layer is not particularly limited. As described above, the bonding layer may be formed by applying a resin solution constituting the bonding layer to a separator and attaching the separator on which the bonding layer is formed to the metal deposition layer, or it may be formed on the metal-deposited layer. Moreover, as the bonding layer, a ready-made product in which a bonding layer is provided on a separator may be used.

A backing sheet may be provided on the laminated film provided with the bonding layer. The backing sheet is appropriately provided when a film insert method is adopted in producing a metallic product. The backing sheet is not particularly limited. By way of an example, the backing sheet may be a polymer sheet allowing for thermoforming, preferably an ABS sheet, a polyacryl-based sheet, a polypropylene sheet, a polyethylene sheet, a polycarbonate-based sheet, an A-PET sheet, a PET-G sheet, a vinyl chloride-based sheet, a polyamide-based sheet, or the like.

A thickness of the backing sheet is not particularly limited. By way of an example, the thickness of the backing sheet is preferably 0.05 to 5 mm, more preferably 0.3 to 3 mm, from the viewpoint of moldability in compression molding and the like.

As the backing sheet, one having a desired surface processing may be used. The surface processing is not particularly limited. By way of an example, the surface processing includes matt processing, satin processing, emboss processing, hairline processing, various patterns, and the like.

The obtained laminated film is provided with a separator. As described above, for the laminated film, a separator provided with a bonding layer in advance may be used, or a bonding layer may be formed on the separator and attached to be contact with the metal deposition layer.

The separator is not particularly limited. By way of an example, the separator is polyethylene terephthalate (PET), polyethylene, polypropylene, or a plastic film, paper, or the like surface-coated with a release agent such as a fluorine-based release agent and a long-chain alkyl acrylate-based release agent.

When the separator is released, the bonding layer is exposed. The exposed bonding layer is attached to the adherend before molding.

Then, the adherend to which the laminated film of this embodiment is attached is appropriately processed into a three-dimensional shape to produce a molded product (metallic product). A method of molding a metallic product is not particularly limited. By way of an example, the molding method includes vacuum molding, TOM (Three dimension Overlay Method) molding, and the like. In TOM molding, the laminated film is applied to an adherend prepared in advance and softened by heat to be integrally molded so as to follow the adherend. On the other hand, in vacuum forming, the laminated film is heated by a heater and softened. Next, the heated laminated film is pressed against a mold having a desired three-dimensional shape while being vacuum-sucked, and deformed so as to follow the shape of the three-dimensional molded product.

The metallic product obtained exhibits a metallic appearance due to a metal deposition layer comprising indium in the daytime. On the other hand, in the nighttime, light can be transmitted towards the outside by irradiating with light from the light source from the back surface.

EXAMPLE

Hereinafter, the present invention will be described in more detail with reference to Examples. The present invention is not limited to these Examples. Unless otherwise limited, "%" means "% by mass", and "part" means "part by mass".

<Example 1>

A base material (thickness: 75 $\mu$m) made of PMMA was prepared. Using a gravure coater, an anchor coating agent solution mixed with acrylic polyol and an isocyanate-based coating material so as to have 1.3 $\mu$m after drying is applied to the base material, which was then dried at 100°C for 1 minute to form an anchor layer. Next, a metal deposition layer was formed on the anchor layer by a vacuum deposition method so that a thickness of the metal deposition layer made of indium becomes 20 nm. Besides, a separator (PET film) with an adhesive layer (thickness: 25 $\mu$m) comprising a blue pigment (C. I. Pigment Blue 15:3) as a colorant so as to be 2% by mass with respect to an acryl-based adhesive was prepared. The metal deposition layer and the adhesive layer (bonding layer) were attached so as to be in contact with each other, the adhesive layer (bonding layer) was transferred to the metal deposition layer, and then the separator was released to produce a laminated film of Example 1.

<Examples 2 to 10, Comparative examples 1 to 32>

A laminated film was produced by the same method as in Example 1 except that a type of a deposited metal of a metal deposition layer, an OD value, etc. were adjusted according to the formulations shown in Table 1. Besides, when using a magenta pigment, a magenta pigment (C. I. Pigment Red 122) was used.

Table 1

| | Deposited metal | Film thickness of metal deposition layer (nm) | Addition amount of blue pigment/ magenta pigment for colorant formulation | Total light transmittance TT[%] | OD value | Transmitted light L* | Transmitted light a* |
|---|---|---|---|---|---|---|---|
| Comparative example 1 | In | 50 | - | 3.0 | 1.45 | - | - |

(continued)

| | Deposited metal | Film thickness of metal deposition layer (nm) | Addition amount of blue pigment/ magenta pigment for colorant formulation | Total light transm ittance TT[%] | OD value | Transmitted light L* | Transmitted light a* |
|---|---|---|---|---|---|---|---|
| Comparative example 2 | In | 40 | - | 4.6 | 1.25 | 23.9 | 2.2 |
| Comparative example 3 | In | 20 | - | 12.9 | 0.78 | 39.1 | 7.3 |
| Comparative example 4 | In | 10 | - | 31.2 | 0.40 | 60.0 | 6.1 |
| Comparative example 5 | Al | 10 | - | 28.5 | 0.55 | 60.4 | -1.1 |
| Comparative example 6 | Al | 20 | - | 9.0 | 1.00 | 35.4 | -0.4 |
| Comparative example 7 | In | 40 | 10/0-2% | 3.8 | 1.41 | 19.4 | -3.2 |
| Comparative example 8 | In | 40 | 10/0-4% | 3.1 | 1.58 | 17.6 | -7.5 |
| Comparative example 9 | In | 40 | 10/5-2% | 4.1 | 1.35 | 20.3 | -0.5 |
| Comparative example 10 | In | 40 | 10/5-4% | 3.9 | 1.42 | 19.5 | -3.4 |
| Comparative example 11 | In | 40 | 10/5-6% | 2.8 | 1.61 | 15.8 | -5.2 |
| Comparative example 12 | In | 40 | 10/5-8% | 2.4 | 1.71 | 14.6 | -6.6 |
| Comparative example 13 | In | 40 | 10/10-2% | 4.3 | 1.31 | 20.7 | 0.9 |
| Comparative example 14 | In | 40 | 10/10-4% | 3.4 | 1.45 | 18.5 | -0.7 |
| Comparative example 15 | In | 40 | 10/10-6% | 3.0 | 1.52 | 16.7 | -1.9 |
| Comparative example 16 | In | 40 | 10/10-8% | 2.6 | 1.62 | 16.2 | -3.2 |
| Comparative example 17 | In | 40 | 10/20-2% | 4.0 | 1.33 | 19.9 | 2.2 |
| Comparative example 18 | In | 40 | 10/20-4% | 3.7 | 1.37 | 19.2 | 2.0 |
| Comparative example 19 | In | 40 | 10/20-6% | 3.3 | 1.45 | 19.8 | 1.7 |
| Comparative example 20 | In | 40 | 10/20-8% | 2.8 | 1.51 | 15.5 | 1.4 |
| Comparative example 21 | In | 40 | 10/30-2% | 4.4 | 1.28 | 21.5 | 3.0 |

(continued)

| | Deposited metal | Film thickness of metal deposition layer (nm) | Addition amount of blue pigment/ magenta pigment for colorant formulation | Total light transm ittance TT[%] | OD value | Transmitted light L* | Transmitted light a* |
|---|---|---|---|---|---|---|---|
| Comparative example 22 | In | 40 | 10/30-4% | 3.6 | 1.37 | 20.4 | 3.3 |
| Comparative example 23 | In | 40 | 10/30-6% | 3.4 | 1.40 | 19.0 | 3.5 |
| Comparative example 24 | In | 40 | 10/30-8% | 3.0 | 1.47 | 16.2 | 3.8 |
| Example 1 | In | 20 | 10/0-2% | 9.6 | 0.99 | 34.2 | -1.4 |
| Comparative example 25 | In | 20 | 10/0-4% | 8.1 | 1.14 | 31.7 | -8.4 |
| Example 2 | In | 20 | 10/5-2% | 10.6 | 0.91 | 36.0 | 2.7 |
| Example 3 | In | 20 | 10/5-4% | 8.8 | 0.99 | 32.9 | -1.6 |
| Comparative example 26 | In | 20 | 10/5-6% | 7.0 | 1.14 | 30.6 | -4.4 |
| Comparative example 27 | In | 20 | 10/5-8% | 6.2 | 1.26 | 27.5 | -6.6 |
| Example 4 | In | 20 | 10/10-2% | 10.9 | 0.88 | 36.4 | 4.8 |
| Example 5 | In | 20 | 10/10-4% | 8.9 | 0.99 | 33.2 | 2.3 |
| Example 6 | In | 20 | 10/10-6% | 7.6 | 1.08 | 31.0 | 0.6 |
| Comparative example 28 | In | 20 | 10/10-8% | 6.6 | 1.17 | 28.3 | -1.1 |
| Example 7 | In | 20 | 10/20-2% | 10.8 | 0.87 | 36.3 | 6.6 |
| Example 8 | In | 20 | 10/20-4% | 9.2 | 0.95 | 33.2 | 6.1 |
| Example 9 | In | 20 | 10/20-6% | 8.2 | 1.00 | 32.4 | 5.5 |
| Comparative example 29 | In | 20 | 10/20-8% | 7.2 | 1.08 | 29.7 | 5.4 |
| Example 10 | In | 20 | 10/30-2% | 10.8 | 0.85 | 36.2 | 7.5 |
| Comparative example 30 | In | 20 | 10/30-4% | 9.7 | 0.90 | 34.3 | 8.1 |
| Comparative example 31 | In | 20 | 10/30-6% | 8.2 | 0.99 | 31.9 | 8.2 |
| Comparative example 32 | In | 20 | 10/30-8% | 7.7 | 1.02 | 30.6 | 8.8 |

| | Transmitted light b* | Reflected light L* | Appearance evaluation color tone | Appearance evaluation transparency | $(a^{*2} + b^{*2})^{1/2}$ | OD value $\times (a^{*2} + b^{*2})^{1/2}$ | Moldability |
|---|---|---|---|---|---|---|---|
| Comparative example 1 | - | 85.6 | - | $\times$ | - | - | $\Delta$ |

(continued)

| | Transmitted light b* | Reflected light L* | Appearance evaluation color tone | Appearance evaluation transparency | $(a^{*2} + b^{*2})^{1/2}$ | OD value $\times (a^{*2} + b^{*2})^{1/2}$ | Moldability |
|---|---|---|---|---|---|---|---|
| Comparative example 2 | 6.9 | 82.1 | × | × | 7.2 | 9.0 | ○ |
| Comparative example 3 | 7.0 | 76.1 | × | ○ | 10.1 | 7.9 | ○ |
| Comparative example 4 | 20.1 | 58.7 | × | ○ | 21.0 | 8.4 | ○ |
| Comparative example 5 | -10.4 | 72.7 | ○ | ○ | 10.5 | 5.8 | × |
| Comparative example 6 | -9.2 | 83.3 | × | ○ | 9.2 | 9.2 | × |
| Comparative example 7 | 1.1 | 83.6 | ○ | × | 3.3 | 4.7 | ○ |
| Comparative example 8 | -1.8 | 83.8 | × | × | 7.7 | 12.2 | ○ |
| Comparative example 9 | 2.2 | 83.7 | ○ | × | 2.2 | 3.0 | ○ |
| Comparative example 10 | -1.0 | 83.0 | ○ | × | 3.5 | 5.0 | ○ |
| Comparative example 11 | -3.2 | 83.8 | × | × | 6.2 | 9.9 | ○ |
| Comparative example 12 | -5.3 | 83.8 | × | × | 8.4 | 14.4 | ○ |
| Comparative example 13 | 2.8 | 83.7 | ○ | × | 2.9 | 3.8 | ○ |
| Comparative example 14 | -0.3 | 83.7 | ○ | × | 0.8 | 1.1 | ○ |
| Comparative example 15 | -2.4 | 83.6 | ○ | × | 3.0 | 4.6 | ○ |
| Comparative example 16 | -4.3 | 83.8 | × | × | 5.3 | 8.7 | ○ |
| Comparative example 17 | 2.7 | 83.7 | ○ | × | 3.5 | 4.7 | ○ |
| Comparative example 18 | 0.6 | 83.6 | ○ | × | 2.1 | 2.8 | ○ |
| Comparative example 19 | -1.8 | 83.6 | ○ | × | 2.5 | 3.6 | ○ |
| Comparative example 20 | -3.3 | 83.6 | ○ | × | 3.6 | 5.4 | ○ |
| Comparative example 21 | 3.6 | 83.6 | ○ | × | 4.7 | 6.0 | ○ |
| Comparative example 22 | 1.4 | 82.8 | ○ | × | 3.6 | 4.9 | ○ |

(continued)

| | Transmitted light b* | Reflected light L* | Appearance evaluation color tone | Appearance evaluation transparency | $(a^{*2} + b^{*2})^{1/2}$ | OD value $\times (a^{*2} + b^{*2})^{1/2}$ | Moldability |
|---|---|---|---|---|---|---|---|
| Comparative example 23 | -0.6 | 83.6 | ○ | × | 3.6 | 5.0 | ○ |
| Comparative example 24 | -2.8 | 83.5 | × | × | 4.7 | 6.9 | ○ |
| Example 1 | 1.3 | 73.8 | ○ | ○ | 1.8 | 1.8 | ○ |
| Comparative example 25 | -5.1 | 70.8 | × | ○ | 9.8 | 11.2 | ○ |
| Example 2 | 1.8 | 72.6 | ○ | ○ | 3.2 | 2.9 | ○ |
| Example 3 | -3.1 | 71.6 | ○ | ○ | 3.5 | 3.5 | ○ |
| Comparative example 26 | -6.2 | 72.3 | × | ○ | 7.6 | 8.7 | ○ |
| Comparative example 27 | -9.2 | 71.5 | × | × | 11.3 | 14.2 | ○ |
| Example 4 | 2.6 | 70.8 | ○ | ○ | 5.5 | 4.8 | ○ |
| Example 5 | -1.5 | 74.6 | ○ | ○ | 2.7 | 2.7 | ○ |
| Example 6 | -4.4 | 72.7 | ○ | ○ | 4.4 | 4.8 | ○ |
| Comparative example 28 | -7.9 | 71.4 | × | ○ | 7.9 | 9.3 | ○ |
| Example 7 | 3.0 | 72.6 | Δ | ○ | 7.2 | 6.3 | ○ |
| Example 8 | -0.4 | 71.8 | ○ | ○ | 6.1 | 5.8 | ○ |
| Example 9 | -4.0 | 72.6 | Δ | ○ | 6.7 | 6.7 | ○ |
| Comparative example 29 | -5.0 | 71.8 | × | ○ | 7.4 | 7.9 | ○ |
| Example 10 | 2.2 | 72.8 | Δ | ○ | 7.9 | 6.7 | ○ |
| Comparative example 30 | 0.2 | 71.8 | × | ○ | 8.1 | 7.3 | ○ |
| Comparative example 31 | -2.7 | 72.9 | × | ○ | 8.6 | 8.5 | ○ |
| Comparative example 32 | -5.0 | 71.2 | × | ○ | 10.1 | 10.3 | ○ |

For each of the laminated films obtained in Examples 1 to 10 and Comparative examples 1 to 32, a total light transmittance (TT), an OD value, values of a transmitted light and a reflected light in a L*a*b* color space (a L* value, an a* value, a b* value of a transmitted light, a L* value of a reflected light), an appearance evaluation (color tone, transparency), and moldability were evaluated according to the following methods. The results are shown in Table 1.

<Total light transmittance (TT)>

The total light transmittance was measured for each laminated film using a haze meter (NDH2000, manufactured by Nippon Denshoku Industries Co. Ltd.) according to JIS K 7361.

<OD value>

The OD value was measured for each laminated film using a transmission densitometer (DM-500, manufactured by SCREEN Holdings Co., Ltd.).

transmitted light and reflected light in L*a*b* color space>

For each laminated film, both of the transmitted light and reflected light in the L*a*b* color space were measured under a condition of using a halogen lamp as the light source, an integrating sphere received light including a specular reflection as the reflected light (a geometric condition d (8°: di)), and an integrating sphere received light including a specular transmission as the transmitted light (geometric condition d (0°: di)), according to JIS K 8722 and CIE 1976, using an ultraviolet-visible near-infrared spectrophotometer (UV-3600, manufactured by Shimadzu Corporation).

<Appearance evaluation (color tone, transparency)>

Each laminated film was attached to an adherend (an acrylic plate (opaque), Acrylite EX432, thickness 3 mm, manufactured by Mitsubishi Chemical Corporation). A rectangular parallelepiped housing made of a black plate that does not transmit light and having an open top was prepared, inside of which an LED light source was placed. The opening of the housing was closed with an adherend to which a laminated film was attached. A LED light source (MJ60LED module (6000K) manufactured by JW-system.co., ltd) was turned on, light was transmitted from the back surface, and the color tone and transparency were visually checked and evaluated according to the following evaluation criteria.

(Evaluation criteria (color tone))

**[0066]**

　　○: Colored to a level without concern
　　△: Slightly colored, but acceptable
　　X: Remarkably colored

(Evaluation criteria (transparency))

**[0067]**

　　○: Had a sufficient brightness
　　×: Had an insufficient brightness

<Moldability>

Each laminated film was attached to an adherend transparent ABS sheet (thickness: 300 $\mu$m). This was heated to a sheet temperature at 140°C using a tabletop vacuum tester (V. former, manufactured by Rayama Pack Co., Ltd.), and then molded so that a draw ratio became 120%. Processability during molding was evaluated according to the following evaluation criteria.

(Evaluation criteria)

**[0069]**

　　○: The metallic luster could be sufficiently maintained.
　　△: The metallic luster was slightly reduced.
　　X: The metallic luster was significantly reduced.

As shown in Table 1, the laminated films in Examples 1 to 10 all had a metallic appearance and were excellent in transparency and moldability.

## Claims

1. A laminated film comprising a base material, an anchor layer, a metal deposition layer and a bonding layer,

   the metal deposition layer comprising indium,
   wherein the thickness of the metal deposition layer is 10 nm or more and 20 nm or less,
   wherein the bonding layer comprises a colorant,
   wherein the colorant comprises at least one of a blue pigment and a magenta pigment,
   wherein an OD value of the laminated film is 1,2 or less,
   wherein, in the laminated film, an a* value and a b* value of a transmitted light in a L*a*b* color space satisfy the following inequality (1):

$$\text{OD value} \times (a^{*2} + b^{*2})^{1/2} \leq 6{,}7 \ ...\ (1),$$

   wherein the OD value of the laminated film is measured according to a method disclosed in the description, and
   wherein, for the laminated film, the a* value and the b* value are measured according to a method disclosed in the description.

2. The laminated film of claim 1, wherein the OD value and the a* value and the b* value of the transmitted light in the L*a*b* color space satisfy the following inequality (2):

$$\text{OD value} \times (a^{*2} + b^{*2})^{1/2} \leq 6{,}0 \ ...\ (2).$$

3. The laminated film of any one of claims 1 or 2, wherein a brightness L* value of a reflected light in the L*a*b* color space is 60 or more,
   wherein the L* value in the laminated film is measured according to a method disclosed in the description.

4. The laminated film of any one of claims 1 to 3, wherein the bonding layer has a film thickness of 10 to 60 $\mu$m.

5. A metallic product using the laminated film of any one of claims 1 to 4.

6. A metallic signboard using the laminated film of any one of claims 1 to 4.

## Patentansprüche

1. Laminierte Folie, umfassend ein Basismaterial, eine Ankerschicht, eine Metallabscheidungsschicht und eine Verbindungsschicht,

   die Metallabscheidungsschicht umfassend Indium,
   wobei die Dicke der Metallabscheidungsschicht 10 nm oder mehr und 20 nm oder weniger beträgt,
   wobei die Verbindungsschicht ein Farbmittel umfasst,
   wobei das Farbmittel mindestens eines von einem blauen Pigment und einem magentafarbenen Pigment umfasst,
   wobei ein OD-Wert der laminierten Folie 1,2 oder weniger beträgt,
   wobei in der laminierten Folie ein a*-Wert und ein b*-Wert eines übertragenen Lichts in einem L*a*b*-Farbraum die folgende Ungleichung (1) erfüllen:

$$\text{AD-Wert} \times (a^{*2} + b^{*2})^{1/2} \leq 6{,}7 \ ...\ (1),$$

   wobei der AD-Wert der laminierten Folie gemäß einem in der Beschreibung offenbarten Verfahren gemessen wird, und
   wobei für die laminierte Folie der a*-Wert und der b*-Wert gemäß einem in der Beschreibung offenbarten Verfahren gemessen werden.

**2.** Laminierte Folie nach Anspruch 1, wobei der OD-Wert und der a*-Wert und der b*-Wert des übertragenen Lichts in dem L*a*b*-Farbraum die folgende Ungleichung (2) erfüllen:

$$\text{AD-Wert} \times (a^{*2} + b^{*2})^{1/2} \leq 6{,}0 \ \ldots \ (2).$$

**3.** Laminierte Folie nach einem der Ansprüche 1 oder 2, wobei ein Helligkeits-L*-Wert eines reflektierten Lichts in dem L*a*b*-Farbraum 60 oder mehr beträgt,
wobei der L*-Wert in der laminierten Folie gemäß einem in der Beschreibung offenbarten Verfahren gemessen wird.

**4.** Laminierte Folie nach einem der Ansprüche 1 bis 3, wobei die Verbindungsschicht eine Foliendicke von 10 bis 60 $\mu$m aufweist.

**5.** Metallprodukt, das die laminiert Folie nach einem der Ansprüche 1 bis 4 verwendet.

**6.** Metallschild, das die laminierte Folie nach einem der Ansprüche 1 bis 4 verwendet.

**Revendications**

**1.** Film stratifié comprenant un matériau de base, une couche d'ancrage, une couche de dépôt métallique et une couche de liaison,

la couche de dépôt métallique comprenant de l'indium,
dans lequel l'épaisseur de la couche de dépôt métallique est de 10 nm ou plus et de 20 nm ou moins,
dans lequel la couche de liaison comprend un colorant,
dans lequel le colorant comprend au moins l'un parmi un pigment bleu et un pigment magenta,
dans lequel une valeur de DO du film stratifié est de 1,2 ou moins,
dans lequel, dans le film stratifié, une valeur a* et une valeur b* d'une lumière transmise dans un espace colorimétrique L*a*b* satisfont à l'inégalité (1) suivante :

$$\text{valeur de DO} \times (a^{*2} + b^{*2})^{1/2} \leq 6{,}7 \ \ldots \ (1),$$

dans lequel la valeur de DO du film stratifié est mesurée selon un procédé divulgué dans la description, et
dans lequel, pour le film stratifié, la valeur a* et la valeur b* sont mesurées selon un procédé divulgué dans la description.

**2.** Film stratifié selon la revendication 1, dans lequel la valeur de DO et la valeur a* et la valeur b* de la lumière transmise dans l'espace colorimétrique L*a*b* satisfont à l'inégalité (2) suivante :

$$\text{valeur de DO} \times (a^{*2} + b^{*2})^{1/2} \leq 6{,}0 \ \ldots \ (2).$$

**3.** Film stratifié selon l'une quelconque des revendications 1 ou 2, dans lequel une valeur de luminosité L* d'une lumière réfléchie dans l'espace colorimétrique L*a*b* est de 60 ou plus,
dans lequel la valeur L* dans le film stratifié est mesurée selon un procédé divulgué dans la description.

**4.** Film stratifié selon l'une quelconque des revendications 1 à 3, dans lequel la couche de liaison a une épaisseur de film de 10 à 60 $\mu$m.

**5.** Produit métallique utilisant le film stratifié selon l'une quelconque des revendications 1 à 4.

**6.** Panneau d'affichage métallique utilisant le film stratifié selon l'une quelconque des revendications 1 à 4.

**EP 4 059 708 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006026946 A
- WO 2006102581 A1
- JP 2012116219 A